# EUROPÄISCHE PATENTSCHRIFT

(11) **EP 3 216 089 B1**
(45) Veröffentlichungstag und Bekanntmachung des Hinweises auf die Patenterteilung: **13.02.2019**
(21) Anmeldenummer: 15794464.6
(22) Anmeldetag: 03.11.2015
(51) Int. Cl.: H01R 12/52, H01R 13/6471, H05K 1/02, H05K 1/11, H01R 12/53

(54) **ELEKTRISCHES INTERFACE**
ELECTRIC INTERFACE
INTERFACE ÉLECTRIQUE

(30) Priorität: 06.11.2014 DE 202014008844 U
(43) Veröffentlichungstag der Anmeldung: 13.09.2017
(73) Patentinhaber: Rosenberger Hochfrequenztechnik GmbH & Co. KG, 83413 Fridolfing (DE)
(72) Erfinder: SANKARARAMAN, Sandeep, Vancouver, WA 98682 (US)
(74) Vertreter: Zeitler Volpert Kandlbinder Patent- und Rechtsanwälte Partnerschaft mbB
(86) Internationale Anmeldenummer: PCT/EP2015/002212
(87) Internationale Veröffentlichungsnummer: WO 2016/070992

(56) Entgegenhaltungen:
- DE-U1-202014 008 844
- US-A1- 2006 046 537
- US-A1- 2007 273 026
- US-A1- 2012 243 184
- US-A1- 2013 210 289
- US-A1- 2013 272 363

## Beschreibung

Die vorliegende Erfindung betrifft ein Elektrisches Interface, insbesondere Interposer, mit einer ersten Anschluss-Ebene mit mindestens einem ersten Kontaktflächenpaar mit jeweils einer ersten und zweiten Kontaktfläche sowie einer zweiten Anschluss-Ebene mit mindestens einem zweiten Kontaktflächenpaar mit jeweils einer dritten und vierten Kontaktfläche, wobei für jeweils ein erstes und zweites Kontaktflächenpaar eine erste elektrische Verbindung die erste Kontaktfläche der ersten Anschlussebene mit der dritten Kontaktfläche der zweiten Anschluss-Ebene und eine zweite elektrische Verbindung die zweite Kontaktfläche der ersten Anschluss-Ebene mit der vierten Kontaktfläche der zweiten Anschluss-Ebene elektrisch verbindet.

Die Erfindung betrifft ebenfalls ein Elektrisches Interface gemäß dem Anspruch 1. In großen Rechneranlagen ist es üblich, dass jeweils mehrere, jeweils einen Server ausbildende Rechnerplatinen in Form von bestückten Leiterplatten, auch "Blades" genannt, über Einsteckeinschübe mit einer sogenannten "Backplane", welche selbst wieder eine bestückte Leiterplatte darstellt, elektrisch und mechanisch verbunden werden. Hierzu sind Winkelverbinder vorgesehen, die einerseits Steckverbinder bzw. Anschlussstellen auf den Blades und andererseits Steckverbinder bzw. Anschlussstellen an der Backplane kontaktieren, um dadurch entsprechende Datenübertragungskanäle zwischen dem jeweiligen Blade und der zugehörigen Backplane herzustellen.

Hierbei ergeben sich jedoch verschiedenartige Schwierigkeiten für die elektrische Verbindung über die Winkelverbinder, die die Übertragungseigenschaften für Hochfrequenzsignale der elektrischen Verbindungen beeinträchtigen. So sollen die Leitungen in dem Leiterplattensteckverbinder alle eine identische Impedanz von 85 Ohm aufweisen. Aufgrund der geometrischen Gegebenheiten weisen jedoch nicht alle Leitungen in einem Winkelsteckverbinder eine identische geometrische Länge auf, wenn diese direkt auf dem kürzesten Wege von der ersten zur zweiten Ebene verlaufend angeordnet sind. Es sind jedoch Phasendifferenzen bei der Übertragung von Hochfrequenzsignalen über die Leitungen der Winkelverbinder zu vermeiden, weshalb die Leitungen häufig wellenförmig innerhalb des Winkelverbinders verlegt sind, so dass alle Leitungen eine identische geometrische und damit auch elektrische Länge aufweise. Dies hat jedoch den Nachteil dass nicht an jeder Stelle zwischen zwei benachbarten Leitern aufgrund des wellenförmig sich ändernden Abstandes der gewünschte Wellenwiderstand von 85 Ohm vorhanden ist. Da sich die Leitungen innerhalb eines Leiterplattensteckverbinders gegenseitig beeinflussen, beispielsweise bei der differenziellen Übertragung von Hochfrequenzsignale, kommt es durch diesen wechselnden Wellenwiderstand im Verlauf der Leitungen zu erheblichen Einschränkungen bei der maximal übertragbaren Bandbreite und Bitrate

Dokumente US2012/243184A1, US2006/046537A1 und US2007/273026A1 offenbaren elektrische Interfaces.

Der Erfindung liegt die Aufgabe zugrunde, ein elektrisches Interface der o.g. Art dahingehend zu verbessern, dass hohe Bandbreiten und Bitraten bei der Übertragung von Hochfrequenzsignalen erzielt werden.

Diese Aufgabe wird erfindungsgemäß durch ein elektrisches Interface der o.g. Art mit den in Anspruch 1 angeführten Merkmalen gelöst. Vorteilhafte Ausgestaltungen der Erfindung sind in den weiteren Ansprüchen beschrieben.

Bei einem elektrischen Interface der o.g. Art ist es erfindungsgemäß vorgesehen, dass die erste elektrische Verbindung zwischen der ersten und dritten Kontaktfläche eine vorbestimmte erste geometrische Länge und die zweite elektrische Verbindung zwischen der zweiten und vierten Kontaktfläche eine vorbestimmte zweite geometrische Länge aufweist, wobei die erste und zweite geometrische Länge unterschiedlich ausgebildet sind.

Dies hat den Vorteil, dass mit dem elektrischen Interface Laufzeit- bzw. Phasenunterschiede, beispielsweise aufgrund von Schaltungen, die an das elektrische Interface angrenzen, zwischen einem ersten elektrischen Signalanteil, welcher über die erste und dritte Kontaktfläche und einem zweiten elektrischen Signalanteil, welcher über die zweite und vierte Kontaktfläche übertragen wird, gezielt beeinflusst und insbesondere auf eine Differenz von Null ausgeglichen werden können.

Zum Ausgleich von Laufzeit- bzw. Phasendifferenzen von Signalen, die über einen elektrischen Winkelverbinder übertragen werden, ist das elektrische Interface zum Zwischenschalten zwischen eine ebene Endfläche eines elektrischen Winkelverbinders, der mindestens ein Leiterpaar zum differentiellen Übertragen von Datensignalen aufweist, und einer Anschlussstelle mit Kontaktflächen auf einer Leiterplatte ausgebildet.

Eine Anordnung der Kontaktflächen in der Art bzw. zum Kontaktieren von Endflächen einer Stern-Vierer-Leitung erzielt man dadurch, dass zwei erste und zweite Kontaktflächenpaare vorgesehen sind, wobei die ersten und zweiten Kontaktflächen der beiden ersten Kontaktflächenpaare auf der ersten Anschluss-Ebene an den Ecken eines Quadrates derart angeordnet sind, dass jeweils eine erste und zweite Kontaktfläche eines ersten Kontaktflächenpaares diagonal gegenüberliegend angeordnet sind, wobei die dritten und vierten Kontaktflächen der beiden zweiten Kontaktflächenpaare auf der zweiten Anschluss-Ebene an den Ecken eines Quadrates derart angeordnet sind, dass jeweils eine dritte und vierte Kontaktfläche eines zweiten Kontaktflächenpaares diagonal gegenüberliegend angeordnet sind.

Einen identischen Ausgleich von Laufzeit- bzw. Phasenunterschiede für alle Leiter- bzw. Kontaktflächenpaare erzielt man dadurch, dass alle ersten elektrischen Verbindungen relativ zueinander eine identische geometrische Länge aufweisen und dass alle zweiten elektrischen Verbindungen relativ zueinander eine identische geometrische Länge aufweisen.

Einen wenig Bauraum benötigendes elektrisches Interface erzielt man dadurch, dass die erste und zweite Anschluss-Ebene parallel zueinander angeordnet sind.

Eine geometrische Länge für die zweite elektrische Verbindung mit einem Wert von im Wesentlichen Null erzielt man dadurch, dass die zweite elektrische Verbindung eine Durchkontaktierung von der ersten zur zweiten Anschluss-Ebene in Richtung senkrecht zu den Anschuss-Ebenen ist.

Einen besonders gut impedanzkontrolliertes elektrischen Interface erzielt man dadurch, dass die zweite und vierte Kontaktfläche jeweils eines ersten und zweiten Kontaktflächenpaares in Richtung senkrecht zur den Anschluss-Ebenen miteinander fluchtend angeordnet sind, wobei die erste und dritte Kontaktfläche jeweils eines ersten und zweiten Kontaktflächenpaares in Richtung senkrecht zur den Anschluss-Ebenen voneinander beabstandet sind.

Einen elektrisch und mechanisch besonders einfachen und funktionssicheren Aufbau erzielt man dadurch, dass eine dritte Ebene ausgebildet ist, welche zwischen der ersten und zweiten Anschluss-Ebene angeordnet ist, wobei die die erste elektrische Verbindung und die zweite elektrische Verbindung in der dritten Ebene ausgebildet sind.

Einen kompakten und elektrisch insbesondere hinsichtlich der Impedanz gut kontrollierbaren Aufbau erzielt man dadurch, dass die dritte Ebene parallel zur ersten und/oder zweiten Anschluss-Ebene ausgebildet ist.

Eine besonders einfachen und elektrisch funktionssicheren Laufzeit- bzw. Phasendifferenz-Ausgleich erzielt man dadurch, dass die erste elektrische Verbindung als eine ebene Leiterbahn ausgebildet ist, die parallel zur ersten und/oder zweiten Anschluss-Ebene verläuft.

Die Erfindung wird im Folgenden anhand der Zeichnung näher erläutert. Diese zeigt in:
- Fig. 1: eine beispielhafte Ausführungsform eines erfindungsgemäßen elektrischen Interface in einer Ansicht von oben,
- Fig. 2: das elektrischen Interface gemäß Fig. 1 in einer Seitenansicht,
- Fig. 3: das elektrischen Interface gemäß Fig. 1 in einer isometrischen Ansicht,
- Fig. 4: das elektrischen Interface gemäß Fig. 1 in einer Ansicht von oben, wobei die Unterseite ausgeblendet ist,
- Fig. 5: das elektrischen Interface gemäß Fig. 1 in einer Ansicht von oben, wobei die Oberseite ausgeblendet ist, so dass nur die Unterseite von oben dargestellt ist,
- Fig. 6: das elektrischen Interface gemäß Fig. 1 in der Anwendung mit einem Winkelverbinder und
- Fig. 7: eine Detailansicht des Winkelverbinders gemäß Fig. 6.

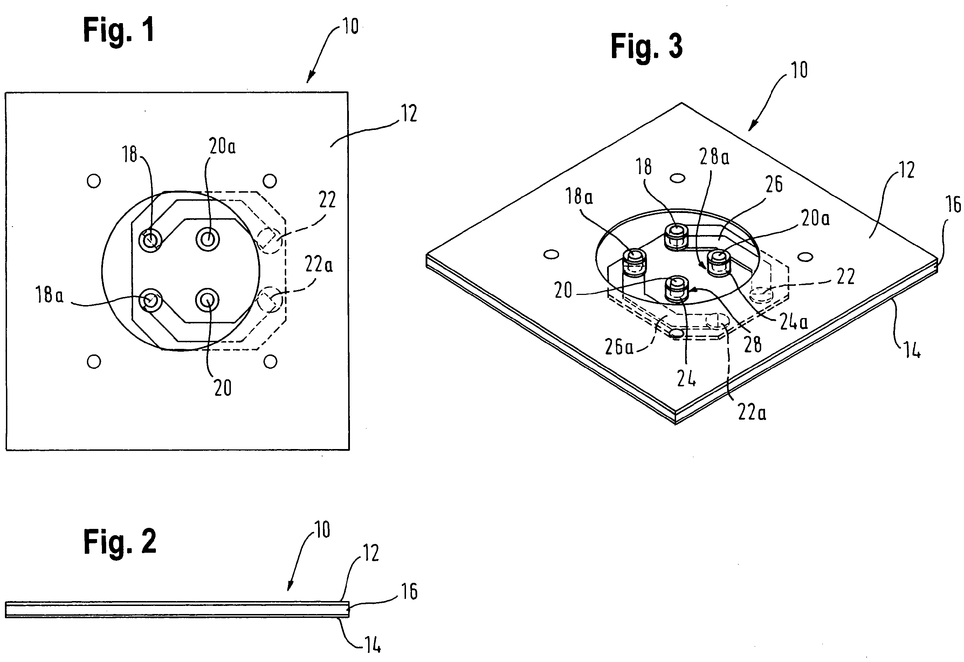

Die in Fig. 1 bis 5 dargestellte, bevorzugte Ausführungsform eines elektrischen Interface 10 weist eine erste Anschlussebene 12, eine zweite Anschlussebene 14 und eine dritte Ebene 16 auf, die alle parallel zueinander ausgerichtet sind, wobei die dritte Ebene 16 zwischen der ersten und zweiten Anschlussebene 12, 14 angeordnet ist. In der ersten Anschlussebene 12 sind zwei erste Kontaktflächenpaare 19, 19a mit jeweils einer ersten Kontaktfläche 18, 18a und einer zweiten Kontaktfläche 20, 20a angeordnet. In der zweiten Anschlussebene 14 sind zwei zweite Kontaktflächenpaare 23, 23a mit jeweils einer dritten Kontaktfläche 22, 22a und einer vierten Kontaktfläche 24, 24a angeordnet. Der Begriff "Ebene" bedeutet hier eine abgegrenzte, ebene bzw. flache Fläche als zweidimensionales Objekt im dreidimensionalen Raum. In der nachfolgend beschriebenen, beispielhaften Ausführungsform sind die "Ebenen" 12, 14, 16 flache (d.h. ohne Krümmung), quadratische Flächen.

Die erste Kontaktfläche 18 des einen ersten Kontaktflächenpaares 19 in der ersten Anschlussebene 12 ist über eine erste elektrische Verbindung 26 mit der dritten Kontaktfläche 22 des einen zweiten Kontaktflächenpaares 23 in der zweiten Anschlussebene 14 elektrisch verbunden. Die zweite Kontaktfläche 20 des einen ersten Kontaktflächenpaares 19 in der ersten Anschlussebene 12 ist über eine zweite elektrische Verbindung 28 mit der vierten Kontaktfläche 24 des einen zweiten Kontaktflächenpaares 23 in der zweiten Anschlussebene 14 elektrisch verbunden.

Die erste Kontaktfläche 18a des anderen ersten Kontaktflächenpaares 19a in der ersten Anschlussebene 12 ist über eine weitere erste elektrische Verbindung 26a mit der dritten Kontaktfläche 22a des anderen zweiten Kontaktflächenpaares 23a in der zweiten Anschlussebene 14 elektrisch verbunden. Die zweite Kontaktfläche 20a des anderen ersten Kontaktflächenpaares 19a in der ersten Anschlussebene 12 ist über eine weitere zweite elektrische Verbindung 28a mit der vierten Kontaktfläche 24a des anderen zweiten Kontaktflächenpaares 23a in der zweiten Anschlussebene 14 elektrisch verbunden.

Mit anderen Worten wird im Interface 10 das eine erste Kontaktflächenpaar 19 in der ersten Anschlussebene 12 auf das eine zweite Kontaktflächenpaar 23 in der zweiten Anschlussebne 14 und das andere erste Kontaktflächenpaar 19a in der ersten Anschlussebene 12 auf das andere zweite Kontaktflächenpaar 23a in der zweiten Anschlussebene 14 umgesetzt.

Die beiden ersten elektrischen Verbindungen 26, 26a sind ebene Leiter, die in der dritten Ebene 16 angeordnet sind und im Wesentlichen parallel zu der ersten und zweiten Anschlussebene 12, 14 verlaufen. Die beiden zweiten elektrischen Verbindungen 28, 28a sind Durchkontaktierungen von der ersten Anschlussebene 12 durch die dritte Ebene 16 hindurch zur zweiten Anschlussebene 14 und verlaufen im Wesentlichen senkechte zu den drei Ebenen 12, 14, 16. Die geometrischen Längen der ersten elektrischen Verbindungen 26, 26a sind identisch und gleichzeitig länger als die geometrischen Längen jeweils der zweiten elektrischen Verbindungen 28, 28a. Die geometrischen Längen der zweiten elektrischen Verbindungen 28, 28a sind ebenfalls zueinander identisch.

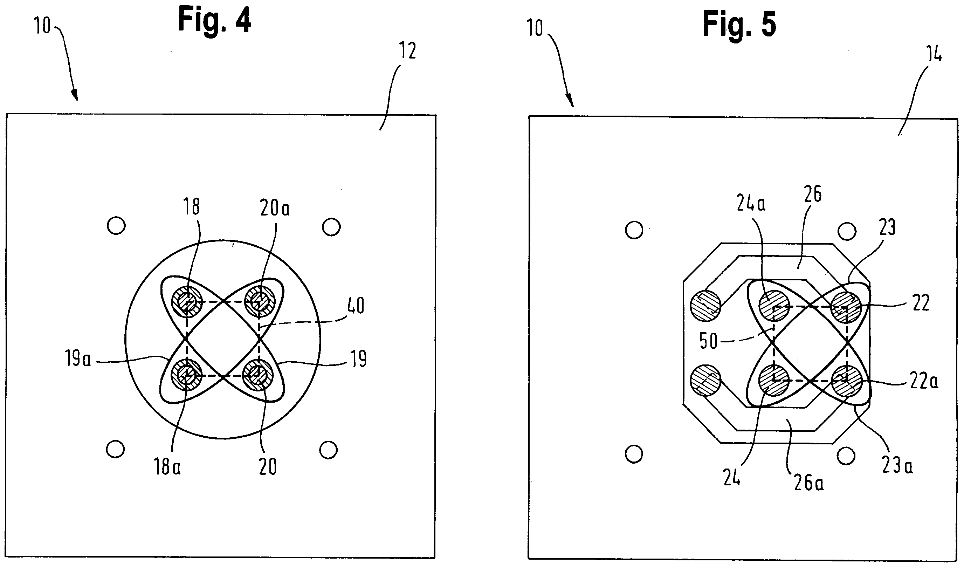

Die ersten und zweiten Kontaktflächen 18, 18a, 20, 20a in der ersten Anschlussebene 12 sind an den Ecken eines gedachten Quadrates 40 (Fig. 4) in der ersten Anschlussebene 12 derart angeordnet, dass die Kontaktflächen 18, 20 bzw. 18a, 20a eines Kontaktflächenpaares 19 bzw. 19a diagonal gegenüberliegend angeordnet sind. Es sind also in der dargestellten Ausführungsform die erste und zweite Kontaktfläche 18, 20 des einen ersten Kontaktflächenpaares 19 bezogen auf das gedachte Quadrat 40 (Fig. 4) diagonal gegenüberliegend und die erste und zweite Kontaktfläche 18a, 20a des anderen ersten Kontaktflächenpaares 19a bezogen auf das gedachte Quadrat 40 (Fig. 4) diagonal gegenüberliegende angeordnet.

Analog sind in der zweiten Anschlussebene 14 die dritten und vierten Kontaktflächen 22, 24 bzw. 22a, 24a der zweiten Kontaktflächenpaare 23 bzw. 23 an den Ecken eines gedachten Quadrates 50 (Fig. 5) in der zweiten Anschlussebene 14 diagonal gegenüberliegend angeordnet. Es sind also in der dargestellten Ausführungsform die dritte und vierte Kontaktfläche 22, 24 des einen zweiten Kontaktflächenpaares 23 bezogen auf das gedachte Quadrat 50 (Fig. 5) diagonal gegenüberliegend und die dritte und vierte Kontaktfläche 22a, 24a des anderen zweiten Kontaktflächenpaares 23a bezogen auf das gedachte Quadrat 50 (Fig. 5) diagonal gegenüberliegende angeordnet.

Die oben beschriebene Anordnung bzw. der sogen. "Footprint" der ersten und zweiten Kontaktflächen 18, 20 und 18a, 20a in der ersten Anschlussebene 12 wird über das erfindungsgemäße Interface 10 zwar in der identischen Dimension und Anordnung, jedoch in Richtung senkrecht zu den Ebenen 12, 14, 16 versetzt auf die oben beschriebenen Anordnung bzw. den "Footprint" der dritten und vierten Kontaktflächen 22, 24 bzw. 22a, 24a in der zweiten Anschlussebene 14 umgesetzt. Gleichzeitig wird mittels der ersten elektrischen Verbindung 26, 26a für die elektrische Verbindung zwischen jeweils einer ersten Kontaktfläche 18 und 18a zu jeweils einer dritten Kontaktfläche 22, 22a der geometrische Weg und damit der elektrische Weg für ein übertragenes Hochfrequenzsignal im Vergleich zu den zweiten elektrischen Verbindungen 28, 28a zwischen jeweils einer zweiten Kontaktfläche 20, 20a und einer vierten Kontaktfläche 24, 24a verlängert.

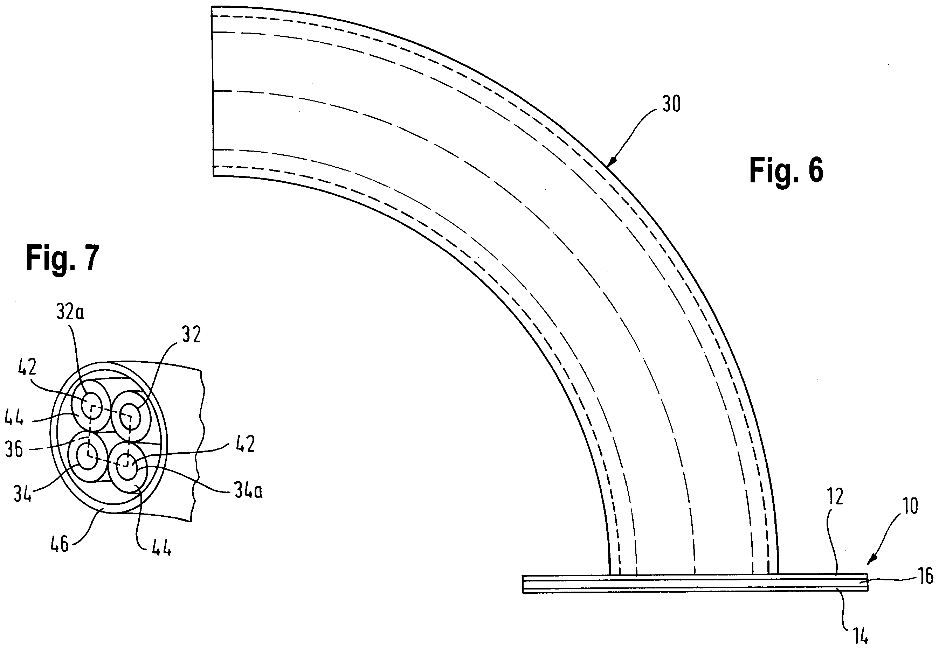

Die Anordnung der Kontaktflächen 18/20, 18a/20a, 22/24, 22a/24a der Kontaktflächenpaare 19, 19a, 23, 23a entspricht der Anordnung von Leitern in einer sogen. Stern-Vierer-Übertragungsleitung, die besonders zur differentialen Übertragung von Hochfrequenz-Signalen geeignet ist. Hierbei dient das erfindungsgeäße Interface als Interposer zwischen einem Winkelverbinder 30, wie in Fig. 6 dargestellt, und einer Leiterplatte (nicht dargestellt). Der in Fig. 6 dargestellte Winkelverbinder enthält, wie aus Fig. 7 ersichtlich, zwei Paar Leiter 32, 34 und 32a, 34a, die in der Art einer Stern-Vierer-Leitung angeordnet sind, wobei an jedem Querschnitt des Winkelverbinders 30 die Leiter an den Ecken eines gedachten Quadrates 36 angeordnet sind, wobei immer zwei Leiter 32, 34 bzw. 32a, 34a eines Leiterpaares bezogen auf das gedachte Quadrat 36 diagonal gegenüberliegend angeordnet sind. Mit anderen Worten sind einerseits die Leiter 32, 34 bezogen auf das gedachte Quadrat 36 diagonal gegenüberliegend angeordnet und andererseits die Leiter 32a, 34a bezogen auf das gedachte Quadrat 36 diagonal gegenüberliegend angeordnet.

Der Winkelverbinder 30 gemäß Fig. 6 weist einen Winkel von 90° auf, so dass die Leiter 34, 34a von einem zum anderen Ende des Winkelverbinders 30 eine kürzere geometrische Länge aufweisen, als die Leiter 32, 32a, da die Leiter 34, 34a auf einer Innenbahn und die Leiter 32, 32a auf einer Außenbahn entlang des 90°-Winkels ber den Winkelverbinder 30 verlaufen. Das Interface 10 ist als sogen. Interposer zwischen dem Winkelverbinder 30 und der nicht dargestellten Leiterplatte derart angeordnet, dass die Leiter 34, 34a mit dem kürzeren geometrischen Weg in dem Winkelverbinder 30 jeweils auf die beiden ersten Kontaktflächen 18 und 18a in der ersten Anschlussebene 12 treffen, so dass die eine erste Kontaktfläche 18 den Leiter 34 und die andere erste Kontaktfläche 18a den Leiter 34a elektrisch kontaktiert. Gleichzeitig kontaktiert der Leiter 32 die eine zweite Kontaktfläche 20 und der Leiter 32a die andere zweite Kontaktfläche 20a in der ersten Anschlussebene 12 elektrisch. Während die jeweils über die Leiter 32 und 32a übertragenen elektrischen Signale direkt von den zweiten Kontaktflächen 20, 20a mittels der Durchkontaktierungen 28, 28a auf kürzestem Wege durch das Interface 10 auf die vierten Kontaktflächen 24, 24a in der zweiten Anschlussebene 14 übertragen werden, erfolgt die Übertragung der jeweils von den Leitern 34, 34a übertragenen Signale über die langen ersten elektrischen Verbindungen 26, 26a auf die dritten Kontaktflächen 22, 22a. Die ersten elektrischen Leitungen 26, 26a sind dabei in ihrer geometrischen Länge derart ausgebildet, dass eine Phasen- bzw. Laufzeitverschiebung zu den auf den anderen Leitern 32, 32a übertragenen Signalen ausgeglichen wird. Mit anderen Worten wird eine Phasen- bzw. Laufzeitverschiebung zwischen den im Winkelverbinder 30 geometrisch kürzeren Leitern 34, 34a relativ zu den im Winkelverbinder 30 geometrisch längeren Leitern 32, 32a mittels der ersten elektrischen Verbindungen 26, 26a ausgeglichen. Hierbei erfolgt der Ausgleich jeweils für ein im Winkelverbinder 30 diagonal gegenüberliegendes Leiterpaar 32, 34 bzw. 32a, 34a, so dass die Phasen- bzw. Laufzeitverschiebung eines Signals im Leiter 34 in Bezug auf den Leiter 32 durch die eine erste elektrische Verbindung 26 sowie die Phasen- bzw. Laufzeitverschiebung eines Signals im Leiter 34a in Bezug auf den Leiter 32a durch die andere erste elektrische Verbindung 26a ausgeglichen wird.

Jeder Leiter 32, 34, 32a und 34a weist einen Kupferdraht 42 mit einem Durchmesser von beispielsweise 0,3 mm sowie eine Beschichtung 44, beispielsweise aus Teflon, auf. Die vier Leiter 32, 34, 32a und 34a sind in einem Dielektrikum 46 eingebettet, welches beispielsweise einen Durchmesser von 1,7 mm aufweist. Das Dielektrikum ist beispielsweise aus dem Werkstoff Polyoxymethylen (Kurzzeichen POM) hergestellt.

Die Anschlussebenen 12, 14 sind beispielsweise aus einem Epoxydharz-Laminat mit der Bezeichnung NELCO® N4000-13 hergestellt und weisen eine Dicke von beispeislweise 4 mm auf.

## Patentansprüche

1. Elektrisches Interface (10), insbesondere Interposer, mit einer ersten Anschluss-Ebene (12) mit zwei ersten Kontaktflächenpaaren (19, 19a) mit jeweils einer ersten und zweiten Kontaktfläche (18, 20, 18a, 20a) sowie einer zweiten Anschluss-Ebene (14) mit zwei zweiten Kontaktflächenpaaren (23, 23a) mit jeweils einer dritten und vierten Kontaktfläche (22, 24, 22a, 24a), wobei für jeweils ein erstes und zweites Kontaktflächenpaar (18, 20, 18a, 20a) eine erste elektrische Verbindung (26, 26a) die erste Kontaktfläche (18, 18a) der ersten Anschlussebene (12) mit der dritten Kontaktfläche (22, 22a) der zweiten Anschluss-Ebene (14) und eine zweite elektrische Verbindung (28, 28a) die zweite Kontaktfläche (20, 20a) der ersten Anschluss-Ebene (12) mit der vierten Kontaktfläche (24, 24a) der zweiten Anschluss-Ebene (14) elektrisch verbindet, wobei die erste elektrische Verbindung (26, 26a) zwischen der ersten und dritten Kontaktfläche (18, 18a, 22, 22a) eine vorbestimmte erste geometrische Länge und die zweite elektrische Verbindung (28, 28a) zwischen der zweiten und vierten Kontaktfläche (20, 20a, 24, 24a) eine vorbestimmte zweite geometrische Länge aufweist, wobei die erste und zweite geometrische Länge unterschiedlich ausgebildet sind,
wobei die ersten und zweiten Kontaktflächen (18, 20, 18a, 20a) der beiden ersten Kontaktflächenpaare (19, 19a) auf der ersten Anschluss-Ebene (12) an den Ecken eines Quadrates (40) derart angeordnet sind, dass jeweils eine erste und zweite Kontaktfläche (18, 20, 18a, 20a) eines ersten Kontaktflächenpaares (19, 19a) diagonal gegenüberliegend angeordnet sind, wobei die dritten und vierten Kontaktflächen (22, 24, 22a, 24a) der beiden zweiten Kontaktflächenpaare (23, 23a) auf der zweiten Anschluss-Ebene (14) an den Ecken eines Quadrates (50) derart angeordnet sind, dass jeweils eine dritte und vierte Kontaktfläche (22, 24, 22a, 24a) eines zweiten Kontaktflächenpaares (23, 23a) diagonal gegenüberliegend angeordnet sind.

2. Elektrisches Interface (10) nach Anspruch 1, **dadurch gekennzeichnet, dass** das elektrische Interface (10) zum Zwischenschalten zwischen eine ebene Endfläche eines elektrischen Winkelverbinders (30), der mindestens ein Leiterpaar (23, 34, 32a, 34a) zum differentiellen Übertragen von Datensignalen aufweist, und einer Anschlussstelle mit Kontaktflächen auf einer Leiterplatte ausgebildet ist.

3. Elektrisches Interface (10) nach mindestens einem der vorhergehenden Ansprüche, **dadurch gekennzeichnet, dass** alle ersten elektrischen Verbindungen (26, 26a) relativ zueinander eine identische geometrische Länge aufweisen und dass alle zweiten elektrischen Verbindungen (28, 28a) relativ zueinander eine identische geometrische Länge aufweisen.

4. Elektrisches Interface (10) nach mindestens einem der vorhergehenden Ansprüche, **dadurch gekennzeichnet, dass** die erste und zweite Anschluss-Ebene (12, 14) parallel zueinander angeordnet sind.

5. Elektrisches Interface (10) nach Anspruch 4, **dadurch gekennzeichnet, dass** die zweite elektrische Verbindung (28, 28a) eine Durchkontaktierung von der ersten zur zweiten Anschluss-Ebene (12, 14) in Richtung senkrecht zu den Anschluss-Ebenen (12, 14) ist.

6. Elektrisches Interface (10) nach Anspruch 4 oder 5, **dadurch gekennzeichnet, dass** die zweite und vierte Kontaktfläche (20, 24, 20a, 24a) jeweils eines ersten und zweiten Kontaktflächenpaares (19, 23, 19a, 23a) in Richtung senkrecht zur den Anschluss-Ebenen (12, 14) miteinander fluchtend angeordnet sind, wobei die erste und dritte Kontaktfläche (18, 22, 18a, 22a) jeweils eines ersten und zweiten Kontaktflächenpaares (19, 23, 19a, 23a) in Richtung senkrecht zur den Anschluss-Ebenen (12, 14) voneinander beabstandet sind.

7. Elektrisches Interface (10) nach mindestens einem der vorhergehenden Ansprüche, **dadurch gekennzeichnet, dass** eine dritte Ebene (16) ausgebildet ist, welche zwischen der ersten und zweiten Anschluss-Ebene (12, 14) angeordnet ist, wobei die erste elektrische Verbindung (26, 26a) und die zweite elektrische Verbindung (28, 28a) in der dritten Ebene (16) ausgebildet sind.

8. Elektrisches Interface (10) nach Anspruch 7, **dadurch gekennzeichnet, dass** die dritte Ebene (16) parallel zur ersten und/oder zweiten Anschluss-Ebene (12, 14) ausgebildet ist.

9. Elektrisches Interface (10) nach mindestens einem der vorhergehenden Ansprüche, **dadurch gekennzeichnet, dass** die erste elektrische Verbindung (26, 26a) als eine ebene Leiterbahn ausgebildet ist, die parallel zur ersten und/oder zweiten Anschluss-Ebene (12, 14) verläuft.

## Claims

1. Electrical interface (10), in particular an interposer, comprising a first connection plane (12) with two first contact surface pairs (19, 19a), each of which comprises a first and second contact surface (18, 20, 18a, 20a), and a second connection plane (14) with two second contact surface pairs (23, 23a), each of which comprises a third and fourth contact surface (22, 24, 22a, 24a), wherein, for each of a first and second contact surface pair (18, 20, 18a, 20a), a first electrical connection (26, 26a) electrically connects the first contact surface (18, 18a) of the first connection plane (12) with the third contact surface (22, 22a) of the second connection plane (14) and a second electrical connection (28, 28a) electrically connects the second contact surface (20, 20a) of the first connection plane (12) with the fourth contact surface (24, 24a) of the second connection plane (14),
wherein the first electrical connection (26, 26a) between the first and third contact surface (18, 18a, 22, 22a) has a specified first geometric length and the second electrical connection (28, 28a) between the second and fourth contact surface (20, 20a, 24, 24a) has a specified second geometric length, the first and second geometric lengths being different,
wherein the first and second contact surfaces (18, 20, 18a, 20a) of the two first contact surface pairs (19, 19a) on the first connection plane (12) are arranged at the corners of a square (40) such that a first and second contact surface (18, 20, 18a, 22a) of a first contact surface pair (19, 19a) are in each case arranged diagonally opposite one another, wherein the third and fourth contact surfaces (22, 24, 22a, 24a) of the two second contact surface pairs (23, 23a) on the second connection plane (14) are arranged at the corners of a square (50) such that a third and fourth contact surface (22, 24, 22a, 24a) of a second contact surface pair (23, 23a) are in each case arranged diagonally opposite one another.

2. Electrical interface (10) according to claim 1, **characterised in that** the electrical interface (10) is designed to be interposed between a flat end surface of an electrical angle connector (30) which has at least one conductor pair (23, 34, 32a, 34a) for the differential transmission of data signals and a connection point with contact surfaces on a printed circuit board.

3. Electrical interface (10) according to at least one of the preceding claims, **characterised in that** all first electrical connections (26, 26a) have an identical geometric length relative to one another and that all second electrical connections (28, 28a) have an identical geometric length relative to one another.

4. Electrical interface (10) according to at least one of the preceding claims, **characterised in that** the first and second connection plane (12, 14) are arranged parallel to one another.

5. Electrical interface (10) according to claim 4, **characterised in that** the second electrical connection (28, 28a) is a through-connection running from the first to the second connection plane (12, 14) in a direction perpendicular to the connection planes (12, 14).

6. Electrical interface (10) according to claim 4 or 5, **characterised in that** the second and fourth contact surface (20, 24, 20a, 24a) of a first and second contact surface pair (19, 23, 19a, 23a) are arranged so as to align with one another in a direction perpendicular to the connection planes (12, 14), wherein the first and third contact surface (18, 22, 18a, 22a) of a first and second contact surface pair (19, 23, 19a, 23a) are spaced apart from one another in a direction perpendicular to the connection planes (12, 14).

7. Electrical interface (10) according to at least one of the preceding claims, **characterised in that** a third plane (16) is formed which is arranged between the first and second connection plane (12, 14), wherein the first electrical connection (26, 26a) and the second electrical connection (28, 28a) are formed in the third plane (16).

8. Electrical interface (10) according to claim 7, **characterised in that** the third plane (16) is formed parallel to the first and/or second connection plane (12, 14).

9. Electrical interface (10) according to at least one of the preceding claims, **characterised in that** the first electrical connection (26, 26a) is designed as a flat conductor track which runs parallel to the first and/or second connection plane (12, 14).

## Revendications

1. Interface électrique (10), en particulier interposeur, comportant un premier plan de raccordement (12) présentant deux premières paires de surfaces de contact (19, 19a) pourvues chacune d'une première et d'une seconde surface de contact (18, 20, 18a, 20a), ainsi qu'un second plan de raccordement (14) présentant deux secondes paires de surfaces de contact (23, 23a) pourvues chacune d'une troisième et d'une quatrième surface de contact (22, 24, 22a, 24a),
dans laquelle
pour une première et une seconde paire respective de surfaces de contact (18, 20, 18a, 20a), une première connexion électrique (26, 26a) relie électriquement la première surface de contact (18, 18a) du premier plan de raccordement (12) à la troisième surface de contact (22, 22a) du second plan de raccordement (14), et une seconde connexion électrique (28, 28a) relie électriquement la seconde surface de contact (20, 20a) du premier plan de raccordement (12) à la quatrième surface de contact (24, 24a) du second plan de raccordement (14),
la première connexion électrique (26, 26a) entre la première et la troisième surface de contact (18, 18a, 22, 22a) présente une première longueur géométrique prédéterminée et la seconde connexion électrique (28, 28a) entre la seconde et la quatrième surface de contact (20, 20a, 24, 24a) présente une seconde longueur géométrique prédéterminée, la première et la seconde longueur géométrique étant réalisées différemment l'une de l'autre,
les premières et les secondes surfaces de contact (18, 20, 18a, 20a) des deux premières paires de surfaces de contact (19, 19a) sont agencées sur le premier plan de raccordement (12) aux coins d'un carré (40) de telle sorte qu'une première et une seconde surface de contact respective (18, 20, 18a, 20a) d'une première paire de surfaces de contact (19, 19a) sont agencées diagonalement à l'opposé l'une de l'autre,
les troisièmes et les quatrièmes surfaces de contact (22, 24, 22a, 24a) des deux secondes paires de surfaces de contact (23, 23a) sont agencées sur le second plan de raccordement (14) aux coins d'un carré (50) de telle sorte qu'une troisième et une quatrième surface de contact respective (22, 24, 22a, 24a) d'une seconde paire de surfaces de contact (23, 23a) sont agencées diagonalement à l'opposé l'une de l'autre.

2. Interface électrique (10) selon la revendication 1,
**caractérisée en ce que**
l'interface électrique (10) est réalisée pour l'interposer entre une surface d'extrémité plane d'un premier connecteur électrique coudé (30) qui présente au moins une paire de conducteurs (23, 34, 32a, 34a) pour la transmission différentielle de signaux de données, et un emplacement de raccordement avec des surfaces de contact sur une carte à circuits imprimés.

3. Interface électrique (10) selon l'une au moins des revendications précédentes,
**caractérisée en ce que**
toutes les premières connexions électriques (26, 26a) présentent une longueur géométrique identique entre elles, et **en ce que** toutes les secondes connexions électriques (28, 28a) présentent une longueur géométrique identique entre elles.

4. Interface électrique (10) selon l'une au moins des revendications précédentes,
**caractérisée en ce que**
le premier et le second plan de raccordement (12, 14) sont agencés parallèlement l'un à l'autre.

5. Interface électrique (10) selon la revendication 4,
**caractérisée en ce que**
la seconde connexion électrique (28, 28a) présentent un via depuis le premier vers le second plan de raccordement (12, 14) dans la direction perpendiculaire aux plans de raccordement (12, 14).

6. Interface électrique (10) selon la revendication 4 ou 5,
**caractérisée en ce que**
la seconde et la quatrième surface de contact (20, 24, 20a, 24a) d'une première et d'une seconde paire respective de surfaces de contact (19, 23, 19a, 23a) sont agencées en alignement l'une avec l'autre dans la direction perpendiculaire aux plans de raccordement (12, 14), la première et la troisième surface de contact (18, 22, 18a, 22a) d'une première et d'une seconde paire respective de surfaces de contact (19, 23, 19a, 23a) étant espacées l'une de l'autre en direction perpendiculaire aux plans de raccordement (12, 14).

7. Interface électrique (10) selon l'une au moins des revendications précédentes,
**caractérisée en ce que**
il est prévu un troisième plan (16) qui est agencé entre le premier et le second plan de raccordement (12, 14), la première connexion électrique (26, 26a) et la seconde connexion électrique (28, 28a) étant réalisées dans le troisième plan (16).

8. Interface électrique (10) selon la revendication 7,
**caractérisée en ce que**
le troisième plan (16) est réalisé parallèlement au premier et/ou au second plan de raccordement (12, 14).

9. Interface électrique (10) selon l'une au moins des revendications précédentes,
**caractérisée en ce que**
la première connexion électrique (26, 26a) est réalisée sous la forme d'une piste conductrice plane qui s'étend parallèlement au premier et/ou au second plan de raccordement (12, 14).
